# FASCICULE DE BREVET EUROPEEN

(11) **EP 2 731 138 B1**
(45) Date de publication et mention de la délivrance du brevet: **17.06.2020**
(21) Numéro de dépôt: 12192033.4
(22) Date de dépôt: 09.11.2012
(51) Int. Cl.: H01L 27/32, G04G 17/04, H01L 51/56

(54) **Procédé de fabrication d'un affichage OLED, affichage OLED résultant et pièce d'horlogerie comprenant un tel affichage**
Herstellungsverfahren eines OLED-Displays, so erzeugtes OLED-Display und ein solches Display umfassende Uhr
Method for manufacturing an OLED display, resulting OLED display and timepiece including such a display

(43) Date de publication de la demande: 14.05.2014
(73) Titulaire: EM Microelectronic-Marin SA, 2074 Marin (CH)
(72) Inventeur: Hamm, Alain, 2523 Lignières (CH)
(74) Mandataire: Supper, Marc

(56) Documents cités:
- EP-A1- 0 078 237
- EP-A2- 1 594 177
- WO-A1-00/28387
- WO-A1-2007/134643
- JP-A- 2006 140 021
- JP-A- 2006 210 246
- JP-A- 2009 218 181
- JP-A- 2010 008 317
- JP-A- 2010 014 475
- US-A1- 2007 228 936
- US-A1- 2011 080 089

## Description

La présente invention concerne un procédé de fabrication d'un dispositif d'affichage utilisant des diodes électroluminescentes organiques encore connues sous leur dénomination anglo-saxonne Organic Light Electroluminescent Diode ou OLED. La présente invention concerne également un dispositif d'affichage à diodes électroluminescentes obtenu par la mise en œuvre de ce procédé, de même qu'une pièce d'horlogerie comprenant un tel dispositif d'affichage.

La présente invention s'intéresse aux dispositifs d'affichage de type OLED. Plus particulièrement, la présente invention s'intéresse aux dispositifs d'affichage connus sous leur dénomination anglo-saxonne Passive Matrix Organic Light Electroluminescent Diode ou PMOLED. Dans les dispositifs d'affichage OLED à matrice passive, le contrôle de l'éclairement est réalisé au moyen d'anodes et de cathodes disposées en bandes perpendiculaires les unes par rapport aux autres et alimentées séparément. Bien que moins efficaces énergétiquement que les dispositifs d'affichage à matrice active encore connus sous leur dénomination anglo-saxonne Active Matrix Organic Light Electroluminescent Diode ou AMOLED, les dispositifs d'affichage de type PMOLED sont moins complexes à réaliser que les dispositifs d'affichage de type AMOLED et ont donc été, de ce fait, les premiers à avoir été introduits en masse sur le marché.

Par rapport à d'autres types de dispositifs d'affichage tels que les cellules à cristaux liquides, les dispositifs d'affichage OLED présentent des avantages très intéressants tels qu'un temps de réponse très rapide, un meilleur rendu des couleurs, un meilleur contraste ou encore une émissivité moins directive offrant donc un angle de vision plus étendu. Par rapport aux dispositifs d'affichage à cristaux liquides, un autre avantage décisif des dispositifs d'affichage OLED est qu'ils ne nécessitent pas de dispositif de rétroéclairage. Par contre, un inconvénient des dispositifs d'affichage OLED est leur sensibilité à l'air et à l'humidité.

Très succinctement résumé, un dispositif d'affichage de type PMOLED comprend un substrat de base, par exemple en verre, sur lequel sont structurées des anodes sous formes de bandes parallèles entre elles. Ces anodes sont réalisées en un matériau transparent conducteur de l'électricité tel que de l'oxyde d'étain-indium encore connu sous sa dénomination anglo-saxonne Indium Tin Oxyde ou ITO. Après dépôt de la couche d'oxyde d'étain-indium sur le substrat de verre et structuration des anodes, on dépose successivement une couche isolante qui a pour but de délimiter entre elles les électrodes de lignes et les électrodes de colonnes, et une couche de séparation dont le rôle est de créer un espacement entre les anodes et les cathodes à venir. On dépose ensuite les couches actives proprement dites qui sont au nombre de trois : une couche d'injection des trous, une couche de transport des trous et une couche de transport des électrons. Finalement, on dépose une couche de matériau conducteur tel que de l'aluminium dans laquelle sont structurées les cathodes. La structure résultante est coiffée d'un couvercle que l'on colle sur le bord du substrat de base. Dans le volume laissé vacant par le couvercle, on peut disposer un piège d'humidité.

Comme on l'a mentionné ci-dessus, les dispositifs d'affichage de type OLED présentent un certain nombre d'avantages très intéressants pour leur utilisation par exemple dans des objets électroniques portables comme des montres-bracelets. Néanmoins, dans le domaine particulier de l'horlogerie, l'homme du métier s'est trouvé confronté à un problème qui, à la connaissance de la demanderesse, n'a pas trouvé de solution jusqu'à ce jour. Ce problème est lié à l'utilisation combinée, dans une pièce d'horlogerie, d'un dispositif d'affichage digital de type OLED et d'un dispositif d'affichage analogique comprenant classiquement un jeu d'aiguilles des heures et des minutes. En effet, dans un tel cas, le dispositif d'affichage OLED se trouve au niveau du cadran de la montre et les aiguilles d'heures et de minutes se déplacent au-dessus du dispositif d'affichage OLED. Or, les aiguilles d'heures et de minutes sont portées par un jeu d'axes concentriques qui doit nécessairement passer à travers le dispositif d'affichage OLED. Mais comme les couches actives et la couche cathodique d'un dispositif d'affichage OLED sont très sensibles à l'air et à l'humidité, il n'est pas envisageable de percer le dispositif d'affichage OLED pour pouvoir laisser passer les axes portant les aiguilles d'heures et de minutes car cela mettrait les couches du dispositif d'affichage OLED sensibles à l'humidité en contact direct avec l'atmosphère.

Par conséquent, un but de la présente invention est de procurer un dispositif d'affichage OLED dans lequel puisse être ménagé un trou pour le passage des axes portant les aiguilles d'heures et de minutes.

Les documents JP 2010 014475 A, JP 2010 008317 A et JP 2009 218181 A divulguent un dispositif d'affichage à diodes organiques électroluminescentes comprenant un substrat coiffé par un couvercle ceux-ci étant percés d'un trou et une pièce d'horlogerie comprenant ce dispositif d'affichage. Les documents JP2006210246 et JP2006140021 divulguent des panneaux d'affichage du type OLED comprenant un couvercle avec une excroissance et un trou pour permettre de monter les aiguilles d'une pièce d'horlogerie.

A cet effet, la présente invention concerne un dispositif d'affichage à diodes électroluminescentes selon la revendication 1.

Grâce à ces caractéristiques, la présente invention procure un dispositif d'affichage à diodes électroluminescentes de type OLED pouvant être traversé de part en part par un trou destiné, dans l'exemple de réalisation préféré de l'invention, à être traversé par un jeu d'axes concentriques portant respectivement une aiguille des heures et une aiguille des minutes. En effet, l'excroissance du couvercle dans laquelle est percé le trou pour le passage des axes des aiguilles d'heures et de minutes est totalement étanche à l'humidité et à l'oxygène, de sorte que les couches actives et la couche cathodique du dispositif d'affichage OLED selon l'invention ne risquent pas d'être altérées. Pour atteindre ce résultat, la présente invention enseigne de prévoir une épargne dans la couche d'espacement et dans la couche cathodique à l'aplomb de l'excroissance du couvercle. On s'est en effet rendu compte, après avoir effectué plusieurs tests, que dans le cas où la couche d'espacement et la couche cathodique subsistaient à l'endroit où l'excroissance du couvercle venait en contact avec les couches actives du dispositif d'affichage OLED, ces couches cathodique et d'espacement subissaient un phénomène de délaminage lors du percement du trou dans l'excroissance du couvercle, ce qui avait pour conséquence la destruction irréversible du dispositif d'affichage OLED. Enfin, on a noté que la qualité du collage entre l'excroissance et le substrat est bien supérieure en l'absence des couches cathodique et d'espacement.

La présente invention concerne également un procédé de fabrication d'un dispositif d'affichage selon la revendication 1, ce procédé comprenant les étapes consistant à :
- se munir d'un substrat et d'un couvercle qui présente une surface plane délimitée le long de son périmètre extérieur par un rebord par lequel le couvercle est destiné à être solidarisé sur le substrat, la surface plane du couvercle étant munie d'une excroissance qui s'étend en direction du substrat ;
- déposer successivement sur le substrat au moins une couche anodique et un revêtement isolant ;
- déposer ensuite une couche d'espacement dans laquelle est ménagée une première épargne dans une première zone qui se situera à l'aplomb de l'excroissance du couvercle une fois que le couvercle sera solidarisé sur le substrat ;
- déposer dans cet ordre une couche active d'injection de trous, une couche active de transport de trous et une couche active de transport d'électrons ;
- déposer une couche cathodique dans laquelle est ménagée une seconde épargne dans une seconde zone qui se situera à l'aplomb de l'excroissance du couvercle une fois que le couvercle sera solidarisé sur le substrat, et
- solidariser le couvercle avec le substrat, puis percer dans l'excroissance du couvercle et dans le substrat un trou dont le diamètre est inférieur aux dimensions géométriques de l'excroissance.

Selon une caractéristique complémentaire du procédé de l'invention, la couche d'espacement, respectivement la couche cathodique, est déposée en deux étapes successives au moyen d'un premier masque dans lequel est ménagée une première ouverture correspondant à une première partie de la couche d'espacement, respectivement de la couche cathodique, qui doit être déposée, ce premier masque masquant au moins partiellement une zone du substrat pour former dans la couche d'espacement, respectivement la couche cathodique, une épargne qui se situera à l'aplomb de l'excroissance une fois que le couvercle sera solidarisé sur le substrat, et au moyen d'un second masque qui présente une seconde ouverture correspondant à une seconde partie de la couche d'espacement, respectivement de la couche cathodique, qui doit être déposée, ce second masque masquant le cas échéant le restant de la zone du substrat pour former dans la couche d'espacement, respectivement la couche cathodique, le restant de l'épargne qui se situera à l'aplomb de l'excroissance une fois que le couvercle sera solidarisé sur le substrat, la seconde ouverture du second masque étant complémentaire de la première ouverture du premier masque de façon que la combinaison de la première ouverture et de la seconde ouverture corresponde à la couche d'espacement, respectivement la couche cathodique, recherchée.

La présente invention concerne également une pièce d'horlogerie comprenant un dispositif d'affichage à diodes électroluminescentes selon la revendication 1 percé d'un trou pour le passage d'un axe d'aiguille des heures et d'un axe d'aiguille des minutes.

D'autres caractéristiques et avantages de la présente invention ressortiront plus clairement de la description détaillée qui suit d'un mode de réalisation d'un dispositif d'affichage de type OLED selon l'invention, cet exemple étant donné à titre purement illustratif et non limitatif seulement en liaison avec le dessin annexé sur lequel :
- la figure 1A est une vue en perspective d'un substrat en verre sur lequel ont été successivement déposées une couche conductrice d'oxyde d'étain-indium et une couche de chrome ;
- la figure 1B est une vue analogue à celle de la figure 1A correspondant à l'étape de structuration de la couche de chrome ;
- la figure 1C illustre l'étape de structuration de la couche conductrice d'oxyde d'étain indium ;
- la figure 1D illustre le dépôt d'une couche isolante ;
- la figure 1E illustre la structuration de la couche isolante de façon à délimiter les pixels de l'affichage matriciel ;
- la figure 1F illustre le dépôt de la couche de séparation ;
- la figure 1G illustre la structuration de la couche de séparation ;
- les figures 1H, 1I et 1J illustrent respectivement le dépôt des couches actives d'injection de trous, de transport des trous et de transport des électrons ;
- la figure 1K illustre le dépôt de la couche cathodique ;
- la figure 2 est une vue en coupe d'un dispositif d'affichage à diodes organiques électroluminescentes selon l'invention ;
- la figure 3 est une représentation schématique d'une montre-bracelet équipée du dispositif d'affichage OLED selon l'invention, et
- les figures 4A, 4B et 4C sont des vues de dessus des premier et second masques utilisés pour le dépôt par évaporation de la couche d'espacement et de la couche cathodique.

La présente invention procède de l'idée générale inventive qui consiste à procurer un dispositif d'affichage à diodes organiques électroluminescentes dans lequel il est possible de percer un trou pour laisser un passage par exemple à des axes d'aiguilles des heures et des minutes. On sait en effet qu'il n'est pas possible de percer directement un trou dans un dispositif d'affichage OLED car cela mettrait les couches actives du dispositif d'affichage OLED en contact avec l'atmosphère et provoquerait leur destruction. Pour remédier à ce problème, la présente invention enseigne de ménager une épargne dans la couche d'espacement et dans la couche cathodique déposées sur le substrat du dispositif d'affichage à diodes organiques électroluminescentes. Autrement dit, à l'endroit correspondant à ces épargnes, les matériaux utilisés pour déposer la couche d'espacement et la couche cathodique sont omis. Ces épargnes sont situées à l'aplomb d'une excroissance prévue dans la face inférieure d'un couvercle qui vient coiffer le dispositif d'affichage OLED en fin de fabrication. Le trou pour le passage des axes d'aiguilles des heures et des minutes est percé dans l'excroissance et dans le couvercle. Cette opération est rendue possible grâce à l'absence de la couche d'espacement et de la couche cathodique à l'endroit où l'excroissance vient en contact avec le substrat. On s'est en effet rendu compte qu'en cas de présence de la couche d'espacement et de la couche cathodique, ces couches font l'objet d'un phénomène de délaminage lors du percement du trou dans l'excroissance du couvercle. Par ailleurs, l'adhésion de l'excroissance sur le substrat est bien meilleure lorsque les couches d'espacement et cathodique sont absentes. Etant parvenu à la conclusion que les couches d'espacement et cathodique devaient être omises dans la zone de l'excroissance, il fallait encore trouver un procédé pour déposer ces couches de la manière voulue. Dans ce but, la présente invention enseigne de déposer la couche d'espacement, respectivement la couche cathodique, en deux étapes successives au moyen de deux masques distincts dont le premier comporte une première ouverture correspondant à une première partie de la couche d'espacement, respectivement de la couche cathodique, à déposer, ce premier masque masquant tout ou partie de la zone du substrat où l'on souhaite créer l'épargne, et dont le second comporte une seconde ouverture qui est le complément de la première ouverture ménagée dans le premier masque et qui, le cas échéant, masque le reste de la zone du substrat où l'on souhaite créer l'épargne. Enfin, l'invention concerne un objet portable tel qu'une pièce d'horlogerie comprenant un dispositif d'affichage à diodes électroluminescentes percé d'un trou pour le passage d'un axe d'aiguille des heures et d'un axe d'aiguille des minutes.

On décrit ci-dessous les différentes étapes du procédé permettant de réaliser un dispositif d'affichage à diodes électroluminescentes ou dispositif d'affichage OLED selon l'invention.

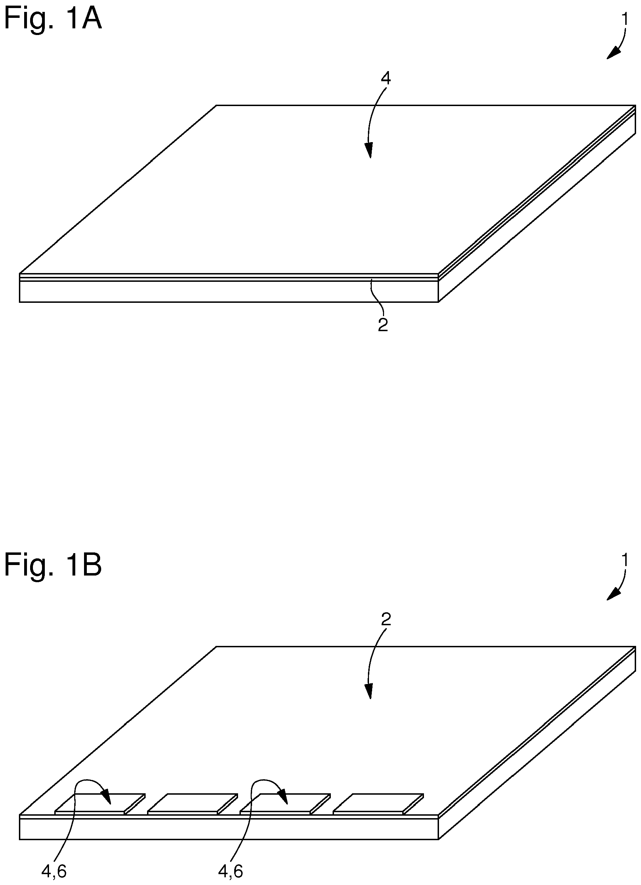

La figure 1A est une vue en perspective d'un substrat 1 par exemple en verre sur la surface duquel ont été successivement déposées une première couche conductrice 2 et une seconde couche conductrice 4. La première couche conductrice 2 est par exemple réalisée en oxyde d'étain-indium, matériau mieux connu sous sa dénomination anglo-saxonne indium-tin oxyde ou ITO, et la seconde couche conductrice 4 est par exemple réalisée en chrome.

A la figure 1B, la seconde couche conductrice 4 a été pratiquement éliminée sur toute sa surface par photolithographie et attaque chimique. Il ne subsiste du chrome qu'au niveau des plages de contact 6 où la présence de ce matériau permet d'améliorer la conductivité électrique.

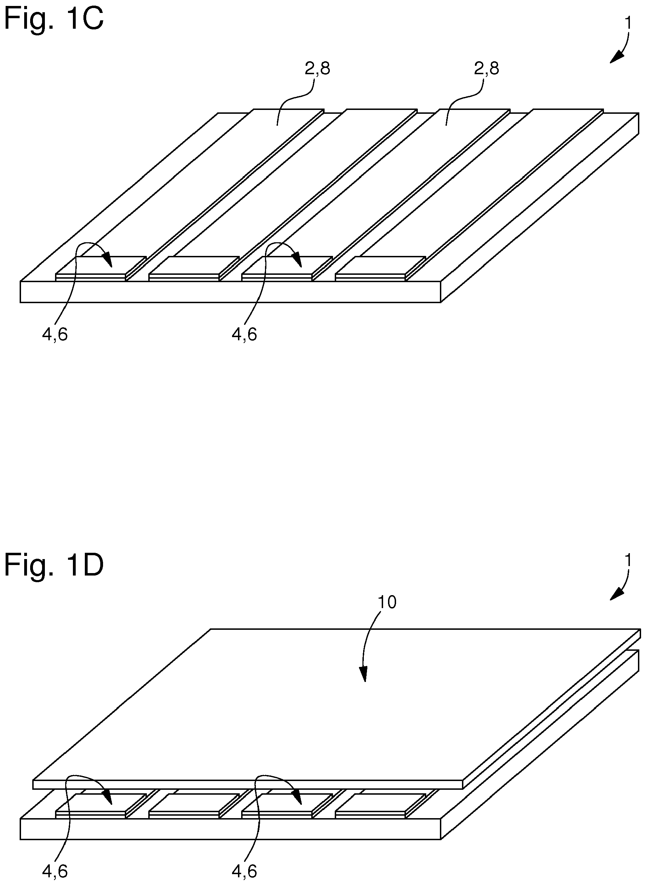

A la figure 1C est illustrée l'étape de structuration des anodes 8. Ces anodes 8 se présentent sous la forme de bandes parallèles entre elles et sont obtenues par photolithographie et attaque chimique de la première couche conductrice 2 en ITO.

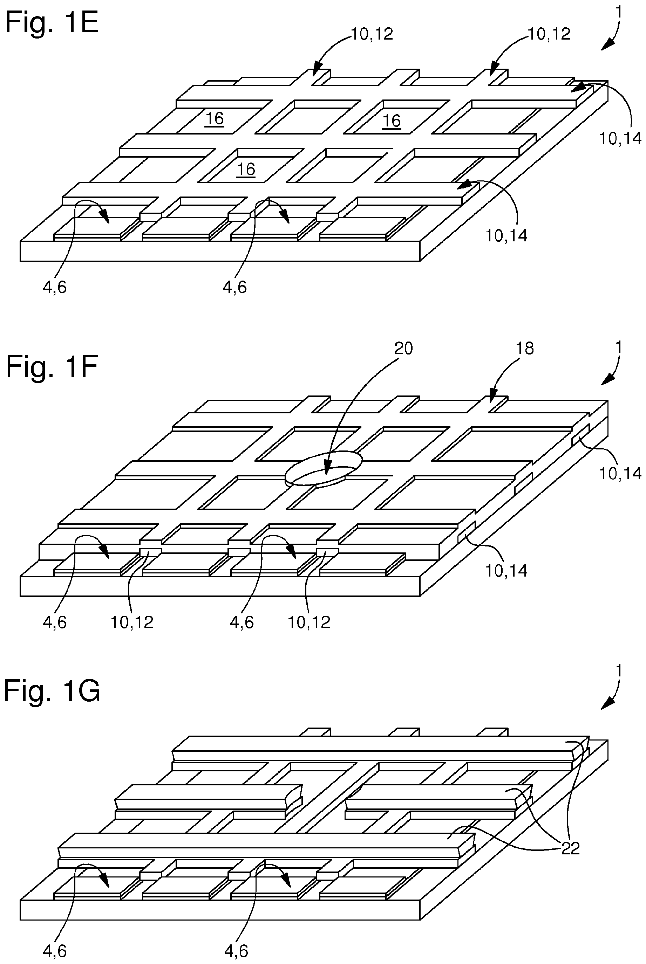

La figure 1D illustre l'étape de dépôt, sur les anodes 8 en ITO, d'une couche isolante 10. Comme on le voit à l'examen de la figure 1E, la couche isolante 10 est structurée selon des lignes 12 et des colonnes 14 de manière à délimiter des zones conductrices 16 qui vont former les pixels d'affichage du dispositif d'affichage OLED selon l'invention.

A la figure 1F, on dépose sur le substrat 1 selon une épaisseur uniforme une couche de matériau d'espacement 18. Cette couche de matériau d'espacement 18 a pour fonction d'écarter les anodes 8 de la cathode qui sera structurée à une étape ultérieure du procédé. On voit que, sensiblement au centre du substrat 1, on a omis de déposer le matériau d'espacement, de façon à créer une épargne 20 située à l'aplomb d'une excroissance prévue dans la face inférieure d'un couvercle qui, comme on le verra en détail ci-après, viendra coiffer le dispositif d'affichage OLED selon l'invention en fin de fabrication.

A la figure 1G, on a structuré la couche d'espacement de manière à former des entretoises 22 qui, dans l'exemple représenté au dessin, s'étendent parallèlement entre elles selon une direction généralement perpendiculaire aux anodes 8.

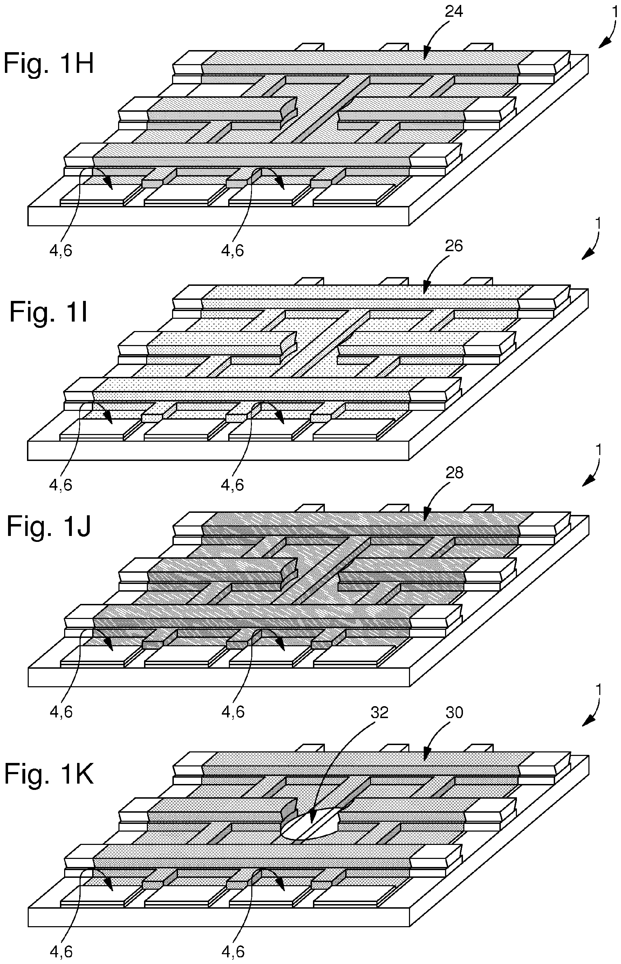

Aux figures 1H, 1I et 1J on dépose à la suite les unes des autres les couches actives du dispositif d'affichage OLED selon l'invention, à savoir une couche 24 d'injection de trous, une couche 26 de transport des trous et une couche 28 de transport des électrons. Ces trois couches 24, 26 et 28 sont déposées de manière non sélective sur toute la surface du substrat 1.

Finalement, comme représenté à la figure 1K, on dépose sur le substrat 1 une couche 30 qui va former la cathode du dispositif d'affichage OLED selon l'invention. Cette couche cathodique 30 est obtenue par évaporation d'un matériau conducteur de l'électricité tel que, non limitativement, de l'aluminium. Il peut également s'agir d'un mélange d'aluminium et de calcium ou bien encore d'un alliage de baryum et d'argent. On voit que, sensiblement au centre du substrat 1, on a omis de déposer la couche cathodique 30, de façon à créer une épargne 32 située à l'aplomb d'une excroissance prévue dans la face inférieure d'un couvercle qui, comme on le verra ci-dessous, va venir coiffer le dispositif d'affichage OLED selon l'invention en fin de fabrication.

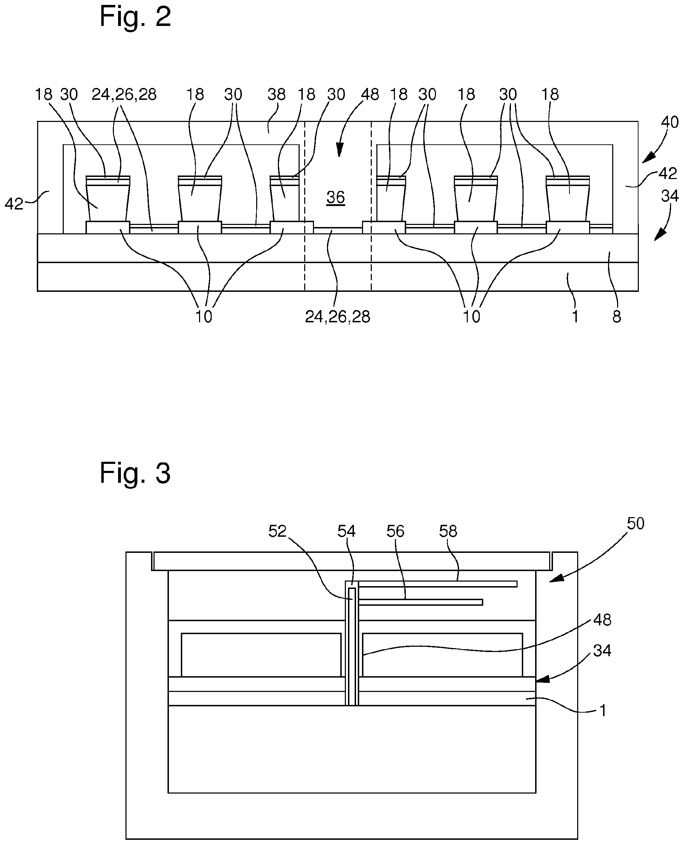

On se réfère maintenant à la figure 2 qui est une vue en coupe d'un dispositif d'affichage à diodes organiques électroluminescentes selon l'invention. Désigné dans son ensemble par la référence numérique générale 34, le dispositif d'affichage OLED selon l'invention comprend le substrat 1 sur lequel ont été successivement déposées la couche anodique 8 en oxyde d'étain-indium ou ITO, la couche isolante 10 et la couche de matériau d'espacement 18. Selon l'invention, cette couche de matériau d'espacement 18 est omise à l'endroit où se trouve l'épargne 20. On rappelle que l'épargne 20 est située à l'aplomb d'une excroissance 36 qui s'étend en direction du substrat 1 et qui est ménagée dans la surface plane 38 d'un couvercle 40 qui vient coiffer le dispositif d'affichage OLED 34 selon l'invention en fin de fabrication.

Le procédé de fabrication du dispositif d'affichage OLED 34 selon l'invention se poursuit par le dépôt non sélectif des couches actives du dispositif d'affichage OLED selon l'invention, à savoir une couche 24 d'injection de trous, une couche 26 de transport des trous et une couche 28 de transport des électrons. Le procédé de fabrication s'achève par le dépôt de la couche cathodique 30. Selon l'invention, cette couche cathodique 30 est omise à l'endroit où se trouve l'épargne 32. On rappelle que l'épargne 32 est située à l'aplomb de l'excroissance 36 qui est ménagée dans la surface plane 38 du couvercle 40 qui vient coiffer le dispositif d'affichage OLED 34 selon l'invention en fin de fabrication.

Finalement, on vient sceller le dispositif d'affichage OLED 34 de manière hermétique au moyen du couvercle 40. Ce couvercle 40 présente le long du périmètre extérieur de sa surface plane 38 un rebord 42 par lequel le couvercle 40 est solidarisé au moyen d'une couche de colle 44 sur le substrat 1. Quant à l'excroissance 36 ménagée dans la surface plane 38 du couvercle 40, elle s'étend en direction du substrat 1 dans la zone où ont été ménagées les épargnes 20 et 32 dans les couches d'espacement 18 et cathodique 30. Par conséquent, l'excroissance 36 est en contact quasi direct avec le substrat 1, seulement séparée de celui-ci par la couche anodique 8 et par les couches actives 24, 26 et 28 qui sont très minces. Une mince couche de colle 46 permet de coller l'excroissance 36 sur le substrat 1.

Conformément à l'invention, on perce dans l'excroissance 36 un trou 48 dont le diamètre est inférieur aux dimensions géométriques de l'excroissance 36, ce trou 48 traversant également le substrat 1. Grâce à cette caractéristique, la présente invention procure un dispositif d'affichage OLED percé d'un trou traversant sans que les couches actives et la couche cathodique ne soient mises en contact avec l'humidité et l'oxygène.

La figure 3 est une représentation schématique d'une montre-bracelet équipée d'un dispositif d'affichage OLED 34 selon l'invention. Dans l'exemple représenté, le dispositif d'affichage OLED 34 fait office de cadran de la montre 50 et l'on met à profit la présence du trou 48 qui traverse le dispositif d'affichage OLED 34 et le substrat 1 pour faire passer deux axes concentriques 52 et 54 qui portent respectivement une aiguille des heures 56 et une aiguille des minutes 58.

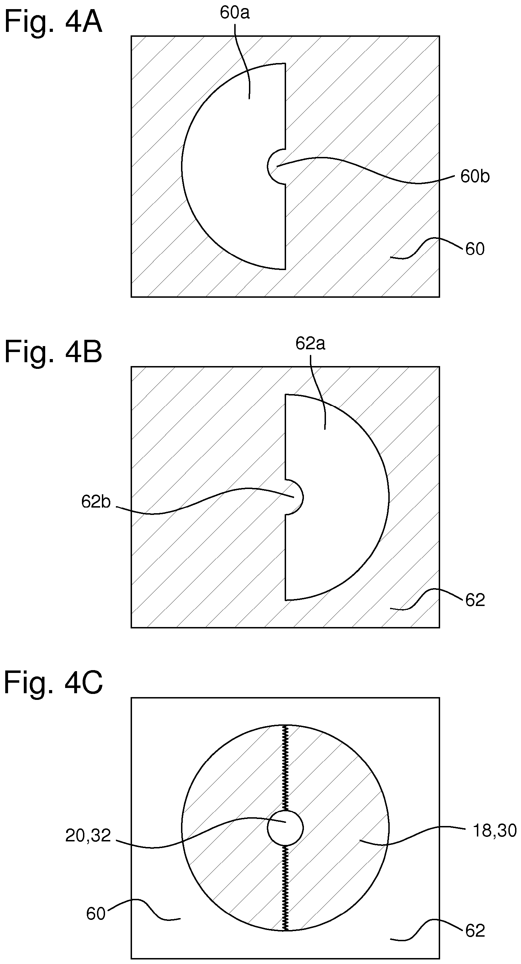

Les figures 4A et 4B sont des vues de dessus des premier et second masques 60 et 62 utilisés pour le dépôt par évaporation de la couche d'espacement 18 et de la couche cathodique 30. Conformément à l'invention, la couche d'espacement 18 et la couche cathodique 30 sont déposées en deux étapes successives à l'aide des premier et second masques 60 et 62. A cet effet, le premier masque 60 comporte une première ouverture 60a correspondant à une première partie de la couche d'espacement 18, respectivement de la couche cathodique 30, à déposer. Le premier masque 60 comporte également un premier cache 60b destiné à masquer tout ou partie de la zone du substrat 1 où l'on souhaite créer les épargnes 20, 32. Par suite, le second masque 62 comporte une seconde ouverture 62a qui est le complément de la première ouverture 60a ménagée dans le premier masque 60 et qui, le cas échéant, comporte un second cache 62b qui est le complément du premier cache 60b et qui masque le reste de la zone du substrat 1 où l'on souhaite créer les épargnes 20 et 32. Finalement, on voit à la figure 4C que la réunion des premier et second masques 60 et 62 permet de délimiter le contour extérieur de la couche d'espacement 18 et de la couche cathodique 30 avec, au centre de ces deux couches 18 et 30, la présence de l'épargne 20 et 32. On comprendra que la figure 4C n'est pas une illustration d'une étape du procédé de fabrication du dispositif d'affichage OLED selon l'invention, mais qu'elle permet simplement d'apprécier que, mis bout-à-bout, les deux masques 60 et 62 présentent des formes parfaitement complémentaires qui délimitent le contour de la couche d'espacement 18 et de la couche cathodique 30 avec l'épargne au centre.

Il va de soi que la présente invention n'est pas limitée au mode de réalisation qui vient d'être décrit et que diverses modifications et variantes simples peuvent être envisagées par l'homme du métier sans sortir du cadre de l'invention tel que défini par les revendications annexées. On comprendra en particulier que bien qu'il ait été mentionné ci-dessus que l'excroissance prévue dans la face inférieure du couvercle soit située sensiblement au centre du dispositif d'affichage OLED selon l'invention, il va de soi que cette excroissance peut être située en un endroit quelconque de la face inférieure du couvercle.

## Revendications

1. Dispositif d'affichage à diodes organiques électroluminescentes, ce dispositif d'affichage (34) comprenant un substrat (1) coiffé par un couvercle (40) qui présente une surface plane (38) délimitée le long de son périmètre extérieur par un rebord (42) par lequel le couvercle (40) est solidarisé sur le substrat (1), la surface plane (38) du couvercle (40) étant munie d'une excroissance (36) qui s'étend en direction du substrat (1), le substrat (1) étant muni d'un empilement de couches, cet empilement de couches comprenant au moins les couches suivantes qui se succèdent dans cet ordre depuis le substrat (1) :
- au moins une anode (8) ;
- une couche isolante (10) structurée selon des lignes (12) et des colonnes (14) de manière à délimiter des zones conductrices (16) qui vont former les pixels d'affichage du dispositif;
- une couche d'espacement (18) sur la couche isolante (10) qui présente une première épargne (20) dans une première zone qui se situe à l'aplomb de l'excroissance (36), cette couche d'espacement (18) étant isolante et étant structurée selon les colonnes (14) ;
- une couche active d'injection de trous (24) ;
- une couche active de transport de trous (26) ;
- une couche active de transport d'électrons (28) ;
- une couche cathodique (30) qui présente une seconde épargne (32) dans une seconde zone qui se situe à l'aplomb de l'excroissance (36),
l'excroissance du couvercle (36) étant solidarisée avec le substrat (1) à travers de la couche anodique (8) et les couches actives (24, 26, 28), l'excroissance (36) étant percée d'un trou (48) dont le diamètre est inférieur aux dimensions géométriques de l'excroissance (36), ce trou (48) traversant également le substrat (1).

2. Procédé de fabrication d'un dispositif d'affichage à diodes organiques électroluminescentes selon la revendication 1, ce procédé comprenant les étapes consistant à :
- se munir d'un substrat (1) et d'un couvercle (40) qui présente une surface plane (38) délimitée le long de son périmètre extérieur par un rebord (42) par lequel le couvercle (40) est destiné à être solidarisé sur le substrat (1), la surface plane (38) du couvercle (40) étant munie d'une excroissance (36) qui s'étend en direction du substrat (1) ;
- déposer successivement sur le substrat au moins une couche anodique (8) et un revêtement isolant (10) ;
- déposer ensuite une couche d'espacement (18) dans laquelle est ménagée une première épargne (20) dans une première zone qui se situera à l'aplomb de l'excroissance (36) du couvercle (40) une fois que le couvercle (40) sera solidarisé sur le substrat (1) ;
- déposer dans cet ordre une couche active d'injection de trous (24), une couche active de transport de trous (26) et une couche active de transport d'électrons (28) ;
- déposer une couche cathodique (30) dans laquelle est ménagée une seconde épargne (32) dans une seconde zone qui se situera à l'aplomb de l'excroissance (36) du couvercle (40) une fois que le couvercle (40) sera solidarisé sur le substrat (1), et
- solidariser le couvercle (40) avec le substrat (1), puis percer dans l'excroissance (36) du couvercle (40) et dans le substrat (1) un trou (48) dont le diamètre est inférieur aux dimensions géométriques de l'excroissance (36).

3. Procédé selon la revendication 2, **caractérisé en ce que** la couche d'espacement (18), respectivement la couche cathodique (30), est déposée en deux étapes successives au moyen d'un premier masque (60) dans lequel est ménagée une première ouverture (60a) correspondant à une première partie de la couche d'espacement (18), respectivement de la couche cathodique (30), qui doit être déposée, ce premier masque (60) comportant également un premier cache (60b) destiné à masquer au moins partiellement une zone du substrat (1) pour former dans la couche d'espacement (18), respectivement la couche cathodique (30), une épargne (20, 32) qui se situera à l'aplomb de l'excroissance (36) une fois que le couvercle (40) sera solidarisé sur le substrat (1), et au moyen d'un second masque (62) qui présente une seconde ouverture (62a) correspondant à une seconde partie de la couche d'espacement (18), respectivement de la couche cathodique (30), qui doit être déposée, ce second masque (62) comportant également, le cas échéant, un second cache (62b) destiné à masquer le restant de la zone du substrat (1) pour former dans la couche d'espacement (18), respectivement la couche cathodique (30), le restant de l'épargne (20, 32) qui se situera à l'aplomb de l'excroissance (36) une fois que le couvercle (40) sera solidarisé sur le substrat (1), la seconde ouverture (62a) et le second cache (62b) du second masque (62) étant complémentaires de la première ouverture (60a) et du premier cache (60b) du premier masque (60), de façon que la combinaison du premier et du second masques (60, 62) délimite le contour de la couche d'espacement (18), respectivement de la couche cathodique (30), recherchées.

4. Pièce d'horlogerie comprenant un dispositif d'affichage à diodes organiques électroluminescentes selon la revendication 1 percé d'un trou (48) pour le passage d'un axe (52) d'aiguille des heures (56) et d'un axe (54) d'aiguille des minutes (58).

## Patentansprüche

1. Anzeigevorrichtung mit organischen Leuchtdioden, wobei diese Anzeigevorrichtung (34) ein Substrat (1) umfasst, das durch einen Deckel (40) überdeckt ist, mit einer ebenen Oberfläche (38), die entlang ihres Außenumfangs durch einen Rand (42) begrenzt ist, durch den der Deckel (40) mit dem Substrat (1) fest verbunden ist, wobei die ebene Oberfläche (38) des Deckel (40) mit einer Ausstülpung (36) versehen ist, die sich in Richtung des Substrats (1) erstreckt, das Substrat (1) mit einem Stapel von Schichten versehen ist, und dieser Stapel von Schichten mindestens die folgenden Schichten umfasst, die in dieser Reihenfolge ausgehend von dem Substrat (1) aufeinanderfolgen:
- mindestens eine Anode (8);
- eine Isolierschicht (10), die in Zeilen (12) und Spalten (14) strukturiert ist, um leitende Bereiche (16) abzugrenzen, die die Anzeigepixel der Vorrichtung bilden;
- eine Abstandshalterschicht (18) auf der Isolierschicht (10), die eine erste Aussparung (20) in einem ersten Bereich aufweist, der lotrecht zur Ausstülpung (36) liegt, wobei diese Abstandshalterschicht (18) isolierend ist und entlang der Spalten (14) strukturiert ist;
- eine aktive Lochinjektionsschicht (24);
- eine aktive Lochtransportschicht (26);
- eine aktive Elektronentransportschicht (28);
- eine Kathodenschicht (30), die eine zweite Aussparung (32) in einem zweiten Bereich aufweist, der lotrecht zur Ausstülpung (36) liegt, wobei die Ausstülpung des Deckel (36) mit dem Substrat (1) durch die Anodenschicht (8) und die aktiven Schichten (24, 26, 28) fest verbunden ist, durch die Ausstülpung (36) ein Loch (48) verläuft, dessen Durchmesser kleiner ist als die geometrischen Abmessungen der Ausstülpung (36), und dieses Loch (48) ebenfalls durch das Substrat (1) verläuft.

2. Verfahren zum Herstellen einer Anzeigevorrichtung mit organischen Leuchtdioden nach Anspruch 1, wobei dieses Verfahren die folgenden Schritte umfasst:
- Bereitstellen eines Substrats (1) und eines Deckel (40), die eine ebene Oberfläche (38) aufweist, die entlang ihres Außenumfangs durch einen Rand (42) begrenzt ist, durch den der Deckel (40) an dem Substrat (1) befestigt werden soll, wobei die ebene Oberfläche (38) des Deckel (40) mit einer Ausstülpung (36) versehen ist, die sich in Richtung des Substrats (1) erstreckt;
- aufeinanderfolgendes Absetzen mindestens einer Anodenschicht (8) und einer isolierenden Beschichtung (10) auf dem Substrat;
- anschließend Absetzen einer Abstandshalterschicht (18), in der eine erste Aussparung (20) in einem ersten Bereich ausgebildet ist, der lotrecht zur Ausstülpung (36) des Deckel (40) liegt, sobald der Deckel (40) an dem Substrat (1) befestigt worden ist;
- Absetzen einer aktiven Lochinjektionsschicht (24), einer aktiven Lochtransportschicht (26) und einer aktiven Elektronentransportschicht (28) in dieser Reihenfolge;
- Absetzen einer Kathodenschicht (30), in der eine zweite Aussparung (32) in einem zweiten Bereich ausgebildet ist, der lotrecht zur Ausstülpung (36) des Deckel (40) liegt, sobald der Deckel (40) an dem Substrat (1) befestigt worden ist, und
- Befestigen des Deckel (40) an dem Substrat (1), anschließend Stechen eines Lochs (48), dessen Durchmesser kleiner ist als die geometrischen Abmessungen der Ausstülpung (36), in die Ausstülpung (36) des Deckel (40) und in das Substrat.

3. Verfahren nach Anspruch 2, **dadurch gekennzeichnet, dass** die Abstandshalterschicht (18) bzw. die Kathodenschicht (30) in zwei aufeinander folgenden Schritten abgesetzt wird, nämlich mittels eines ersten Schilds (60), in dem eine erste Öffnung (60a) ausgebildet ist, die einem ersten Teil der Abstandshalterschicht (18) bzw. der Kathodenschicht (30), die abgesetzt werden soll, entspricht, wobei dieser erste Schild (60) ferner eine erste Abdeckung (60b) aufweist, die dazu bestimmt ist, einen Bereich des Substrats (1) zumindest teilweise zu verdecken, um in der Abstandshalterschicht (18) bzw. der Kathodenschicht (30) eine Aussparung (20, 32) zu bilden, die lotrecht zur Ausstülpung (36) liegt, sobald der Deckel (40) an dem Substrat (1) befestigt worden ist, und mittels eines zweiten Schilds (62), der eine zweite Öffnung (62a) aufweist, die einem zweiten Teil der Abstandshalterschicht (18) bzw. der Kathodenschicht (30), die abgesetzt werden soll, entspricht, wobei dieser zweite Schild (62) ferner gegebenenfalls eine zweite Abdeckung (62b) aufweist, die dazu bestimmt ist, den verbleibenden Bereich des Substrats (1) zu verdecken, um in der Abstandshalterschicht (18) bzw. der Kathodenschicht (30) die verbleibende Aussparung (20, 32) zu bilden, die lotrecht zur Ausstülpung (36) liegt, sobald der Deckel (40) an dem Substrat (1) befestigt worden ist, wobei die zweite Öffnung (62a) und die zweite Abdeckung (62b) des zweiten Schilds (62) zu der ersten Öffnung (60a) bzw. der erster Abdeckung (60b) des ersten Schilds (60) komplementär sind, so dass die Kombination des ersten und des zweiten Schilds (60, 62) die angestrebte Kontur der Abstandshalterschicht (18) bzw. der angestrebten Kathodenschicht (30) begrenzt.

4. Uhr, umfassend eine Anzeigevorrichtung mit organischen Leuchtdioden nach Anspruch 1, durch die ein Loch (48) für den Durchgang einer Welle (52) für den Stundenzeiger (56) und einer Welle (58) für den Minutenzeiger (58) verläuft.

## Claims

1. Organic light emitting diode display device, said display device (34) including a substrate (1) covered by a cover (40) which has a plane surface (38) delimited along the external perimeter thereof by an edge (42), via which the cover (40) is secured to the substrate (1), the plane surface (38) of the cover (40) being provided with a protuberance (36) which extends in the direction of the substrate (1), the substrate (1) being provided with a stack of layers, said stack of layers comprising at least the following layers which succeed each other in the following order starting from the substrate (1):
- at least one anode (8);
- an insulating layer (10) structured in lines (12) and columns (14) so as to delimit conductive areas (16) which will form the display pixels of the device;
- a spacer layer (18) on the insulating layer (10) which has a first exclusion area (20) in a first area which is located plumb with the protuberance (36), said spacer layer (18) being insulating and being structured along the lines (14);
- an active hole injection layer (24);
- an active hole transport layer (26);
- an active electron transport layer (28);
- a cathode layer (30) which has a second exclusion area (32) in a second area which is located plumb with the protuberance (36);
the protuberance (36) of the cover being joined to the layer with which the substrate (1) through the anodic layer (8) and the active layers (24, 26, 28), a hole (48), whose diameter is smaller than the geometrical dimensions of the protuberance (36), being made in the protuberance (36), and said hole (48) also passing through the substrate (1).

2. Method of manufacturing an organic light emitting diode display device according to claim 1, said method including the steps consisting in:
- taking a substrate (1) and a cover (40) which has a plane surface (38) delimited along the external periphery thereof by an edge (42), via which the cover (40) is intended to be secured to the substrate (1), the plane surface (38) of the cover (40) being provided with a protuberance (36), which extends in the direction of the substrate (1);
- depositing in succession on the substrate (1) at least an anode layer (8) and an insulating coating (10);
- then depositing a spacer layer (18) in which a first exclusion area (20) is arranged in a first area which will be located plumb with the protuberance (36) of the cover (40) once the cover (40) is secured to the substrate (1);
- depositing an active hole injection layer (24), an active hole transport layer (26) and an active electron transport layer (28) in that order;
- depositing a cathode layer (30) in which a second exclusion area (32) is arranged in a second area which will be plumb with the protuberance (36) of the cover (40), once the cover (40) is secured to the substrate (1), and
- joining the cover (40) to the substrate (1), then making a hole (48), whose diameter is smaller than the geometrical dimensions of the protuberance (36), in the protuberance (36) of the cover (40) and in the substrate (1).

3. Method according to claim 2, **characterized in that** the spacer layer (18), respectively the cathode layer (30), is deposited in two successive steps by means of a first mask (60), in which there is arranged a first aperture (60a) corresponding to a first portion of the spacer layer (18), respectively of the cathode layer (30), to be deposited, said first mask (60) also including a first cover portion (60b) intended to at least partially conceal an area of the substrate (1) so as to form, in the spacer layer (18), respectively in the cathode layer (30), an exclusion area (20, 32), which will be plumb with the protuberance (36) once the cover (40) is secured to the substrate (1); and by means of a second mask (62), which has a second aperture (62a) corresponding to a second portion of the spacer layer (18), respectively of the cathode layer (30), to be deposited, said second mask (62) also including, if necessary, a second cover portion (62b) for concealing the remainder of the area of the substrate (1), so as to form in the spacer layer (18), respectively in the cathode layer (30), the rest of the exclusion area (20, 32) which will be located plumb with the protuberance (36) once the cover (40) is secured to the substrate (1), the second aperture (62a) and the second cover portion (62b) of the second mask (62) being complementary to the first aperture (60a) and the first cover portion (60b) of the first mask (60) so that the combination of the first and second masks (60, 62) delimits the desired contour of the spacer layer (18), respectively of the cathode layer (30).

4. Timepiece comprising an organic light emitting diode display device according to claim 1 in which a hole (48) is made for the passage of an arbour (52) of an hour hand (56) and an arbour (54) of a minute hand (58).
